# EUROPEAN PATENT APPLICATION

(11) **EP 3 937 384 A1**
(43) Date of publication of application: **12.01.2022**
(21) Application number: 20214363.2
(22) Date of filing: 15.12.2020
(51) Int. Cl.: H03M 13/11, H03M 13/00

(54) **APPARATUSES, DEVICES, METHODS AND COMPUTER PROGRAMS FOR GENERATING AND EMPLOYING LDPC MATRICES**

(30) Priority: 06.07.2020 US 202016920812
(71) Applicant: INTEL Corporation, Santa Clara, CA 95054 (US)
(72) Inventor: VANAPARTHY, Santhosh, Santa Clara, CA California 95054 (US); MOTWANI, Ravi, Fremont, CA California 94539 (US); PALANGAPPA, Poovaiah, San Jose, CA California 95122 (US)
(74) Representative: 2SPL Patentanwälte PartG mbB

(57) **Abstract**

Examples relate to apparatuses, devices, methods, and computer programs for generating and employing LDPC (low-density parity-check code) matrices, and to communication devices, memory devices or storage devices comprising such apparatuses or devices. An apparatus for generating an LDPC matrix comprises processing circuitry. The processing circuitry is configured to generate the LDPC matrix using a generator algorithm. The LDPC matrix is generated for codewords with one or more punctured or erased bits. The LDPC matrix is generated observing one or more constraints. For example, the one or more constraints may comprise one or more of the following: a) for each column corresponding to a punctured or erased bit, the LDPC matrix comprises a row comprising a 1 in the column and a 0 in the other columns corresponding to a punctured or erased bit, b) in a row for a given check node, at most two 1s are present in columns corresponding to punctured or erased bits, and c) each column corresponding to a punctured or erased bit has a column weight of at least 7 and at most 35.

## Description

### Field

Examples relate to apparatuses, devices, methods, and computer programs for generating and employing LDPC (low-density parity-check code) matrices, and to communication devices, memory devices or storage devices comprising such apparatuses or devices.

### Background

LDPC codes are a widely used error correction mechanism in non-volatile memories and many other modern communication systems such as 5G (mobile communication in 5^{th} generation cellular mobile communication systems), PON (Passive Optical Network), etc. Erasure decoding followed by error recovery is typically done in the decoding of Low-Density Parity-Check codes in different scenarios - When punctured bits are involved, and/or when a portion of the codeword is erased (e.g., due to partition or die fails). For hard decision decoding, it is straightforward to design LDPC codes with good performance. Designing good LDPC codes for soft reads is challenging when punctured or erased bits are involved. More particularly, when soft information is available, obtaining good performance is challenging when erased or punctured bits are present. In some approaches, the number of punctured bits or erased bits is limited, the performance available in the soft reads is not fully exploited. Accordingly, the full capacity of the punctured bits in the soft reads or the use of soft information in the erasure mode may not be achieved. As a result, the achievable performance may be limited.

### Brief description of the Figures

Some examples of apparatuses and/or methods will be described in the following by way of example only, and with reference to the accompanying figures, in which
- Fig. 1a: shows a block diagram of an example of an apparatus or device for generating an LDPC matrix;
- Fig. 1b: shows a flow chart of an example of a method for generating an LDPC matrix;
- Fig. 2a: shows a block diagram of an example of a decoder apparatus or of a decoder device;
- Fig. 2b: shows a flow chart of an example of a decoder method;
- Fig. 2c: shows a block diagram of a communication device comprising a decoder apparatus or decoder device;
- Fig. 3: shows a block diagram of a memory device comprising a decoder apparatus or decoder device;
- Fig. 4: shows a block diagram of a storage device comprising a decoder apparatus or decoder device;
- Fig. 5a: shows a diagram showing a performance comparison in Punctured vs Unpunctured Codes for Hard Decision Decoding;
- Fig. 5b: shows a diagram showing a performance comparison in Punctured vs Unpunctured Codes for Hard Decision Decoding and Soft Decision Decoding;
- Fig. 5c: shows a diagram showing a performance comparison in Punctured Codes according to a first construction, Punctured Codes according to a second construction and Unpunctured Codes for Hard Decision Decoding and Soft Decision Decoding;
- Figs. 6a: and 6b show the connection differences for punctured bits between a first construction and a second construction; and
- Figs. 6c: to 6e show example configurations for two, three and four punctured nodes in the base graph.

### Detailed Description

Some examples are now described in more detail with reference to the enclosed figures. However, other possible examples are not limited to the features of these examples described in detail. Other examples may include modifications of the features as well as equivalents and alternatives to the features. Furthermore, the terminology used herein to describe certain examples should not be restrictive of further possible examples.

Throughout the description of the figures same or similar reference numerals refer to same or similar elements and/or features, which may be identical or implemented in a modified form while providing the same or a similar function. The thickness of lines, layers and/or areas in the figures may also be exaggerated for clarification.

When two elements A and B are combined using an 'or', this is to be understood as disclosing all possible combinations, i.e. only A, only B as well as A and B, unless expressly defined otherwise in the individual case. As an alternative wording for the same combinations, "at least one of A and B" or "A and/or B" may be used. This applies equivalently to combinations of more than two elements.

If a singular form, such as "a", "an" and "the" is used and the use of only a single element is not defined as mandatory either explicitly or implicitly, further examples may also use several elements to implement the same function. If a function is described below as implemented using multiple elements, further examples may implement the same function using a single element or a single processing entity. It is further understood that the terms "include", "including", "comprise" and/or "comprising", when used, describe the presence of the specified features, integers, steps, operations, processes, elements, components and/or a group thereof, but do not exclude the presence or addition of one or more other features, integers, steps, operations, processes, elements, components and/or a group thereof.

Various examples of the present disclosure relate to the connectivity in LDPC codes for erasure decoding with the goal of having a good soft-read performance.

For many communication systems, soft reads are the primary mechanism to achieve the desired Uncorrectable Bit-Error Rate (UBER). As such, error-control codes with good soft read performance are crucial for the viability of these products. Also, some memory products need die-fail support, which means the bits in the failed die need to be recovered through erasure decoding. The techniques described in the present disclosure may facilitate error-correction schemes with superior correctability in both soft reads and die-fail cases, which will ultimately help deliver cheaper and better products to the customers.

Some LDPC decoders support a so-called erasure decoding mode, in which punctured or erased bits are supported. In general, an erased bit may be seen as a bit that is identified as not being properly received, e.g. due to interference on the channel, or due to the defect of a hardware component. For example, a decoder that supports erasure decoding can be used to provide protection from die fails. A punctured bit may be seen as a bit that is purposefully omitted, e.g. in order to decrease the number the bits required for transmitting the codeword. Puncturing is e.g. used in wireless communication systems having varying channel conditions. With good channel conditions, shorter codewords having fewer bits can be transmitted, with worse channel conditions, longer codewords having more bits can be transmitted. The same LDPC matrix can be used for both codeword lengths by "puncturing" out the superfluous bits, which are then reconstructed in the course of the LDPC iterative decoding.

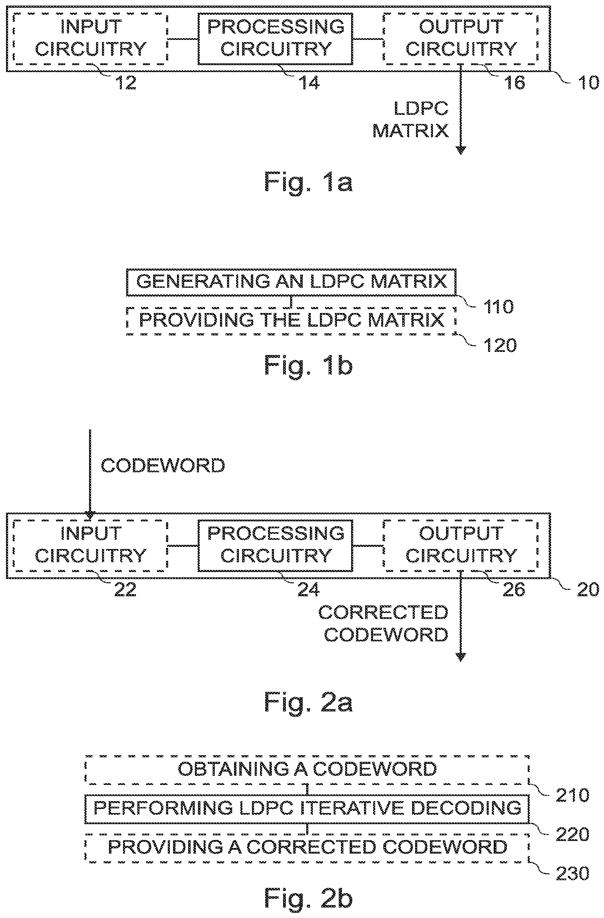

Fig. 1a shows a block diagram of an example of an apparatus 10 or device 10 for generating an LDPC matrix. The components of the device 10 are defined as component means, which correspond to the respective structural components of the apparatus 10. The apparatus / device 10 comprises processing circuitry / processing means 14 configured to generate the LDPC matrix using a generator matrix. The apparatus may comprise one or more further optional components, such as input circuitry / input means 12 or output circuitry / output means 16, which may be coupled with the processing circuitry / processing means 14. The LDPC matrix is generated for codewords with one or more punctured or erased bits. The LDPC matrix is generated observing one or more constraints.

Fig. 1b shows a flow chart of an example of a corresponding method for generating an LDPC matrix. The method comprises generating 110 the LDPC matrix using the generator algorithm. The LDPC matrix is generated for codewords with one or more punctured or erased bits. The LDPC matrix is generated observing one or more constraints. The method may further comprise providing 120 the LDPC matrix, e.g. via an interface or machine-readable storage medium.

The following description relates to the apparatus / device 10 of Fig. 1a as well as the corresponding method of Fig. 1b.

Various examples of the present disclosure relate to the generation of an LDPC matrix. LDPC are codes that are being used to provide both error detection and error correction for codewords comprising LDPC parity information. Such codewords are, for example, used in communication systems for transmitting information over a lossy channel, or in memory or storage applications, where transmission and/or memory/storage errors can be recovered using such codes. In general, an LDPC decoder takes a codeword as an input, and uses a so-called parity-check matrix (also called H matrix) to calculate a syndrome of the codeword (using a matrix multiplication). The afore-mentioned LDPC matrix is such a parity-check matrix or H matrix. The LDPC matrix comprises a plurality of columns corresponding to a plurality of code bits of the codeword, and one or more columns corresponding to one or more punctured (or erased) bits of the codeword. The component "low-density" in LDPC refers to the sparseness of the H matrix, in which only few non-zero elements (e.g. logical ones, or other non-binary values when a non-binary LDPC code is used) are interspersed among zeros. Accordingly, while the following description relates to "Is" and "0s", the same concept may be applied to "non-zero values" and "zero values". The syndrome indicates whether the codeword is correct - if the syndrome is 0 (i.e. all bits of the logical syndrome are logical 0) the codeword is correct. If not, or rather as long as this is not the case (and a maximal number of iterations has not been reached), an iterative process involving message passing is used to correct the code word, by passing "messages" between the variable bit nodes (of the codeword) and the so-called check nodes (of the syndrome) according to a decoder algorithm.

The processing circuitry 14 is configured to generate the LDPC matrix using the generator algorithm. In general, the generator algorithm may comprise a set of instructions for programmatically generating the LDPC matrix. A naive approach to generating an LDPC would be to randomly generate matrices, and to test them out on various codewords, with various inserted bit errors. In various examples, however, the generator algorithm is generated based on a set of constraints. For example, this set of constraints may be focused on improving a so-called soft-read performance of a decoder using such a matrix, while taking into account the presence of punctured or erased bits. As mentioned before, an erased bit may be seen as a bit that is identified as not being properly received, and a punctured bit may be seen as a bit that is purposefully omitted. During decoding, these bits may be initially marked as "unknown" during the iterative LDPC decoding process. Usually, these bits can be recovered in the first few iterations of the LDPC decoding process. Accordingly, the LDPC matrix is generated for codewords with one or more punctured or erased bits, e.g. for codewords that may or may not contain a punctured bit or an erased bit.

Decoder algorithms for LDPC decoding can be assigned to either of two groups of decoder algorithms - hard-decision decoding algorithms, and soft-decision decoding algorithms. In hard-decision decoding algorithms, a fixed set of values is supported as input values, usually binary 0 and 1. In soft-decision decoding algorithms, however, a whole range of values is supported, often in the range between 0 and 1. Examples for such soft-decision decoding algorithms are belief-propagation-based algorithms or min-sum-based algorithms. For example, the distance of the values from the integer values may indicate the reliability of the respective values. The respective decoding algorithms use this additional information to provide an improved decoding efficiency. In various examples of the present disclosure, the LDPC matrix is generated for use with a soft-decision decoding algorithm. The LDPC matrix may be an LDPC matrix for use with an LDPC soft-decision decoding algorithm.

As mentioned before, the LDPC matrix is generated observing one or more constraints, e.g. one or more constraints that are focused in improving soft-decision decoding performance. These constraints may be differentiated from parameters, such as codeword size, number of check nodes, and number or location of punctured bits.

For example, the one or more constraints may comprise, that for a given check node, the bits that were erased or punctured are recoverable in the first two iterations of a corresponding LDPC iterative decoding algorithm. In general, the bits that were erased or punctured are recoverable in the first two iteration by including, for each column corresponding to a punctured (or erased) bit, a row comprising a 1 (or non-binary / non-zero value) in the column and a 0 in the other columns corresponding to a punctured (or erased) bit. In other words, the LDPC may be generated to include for each column corresponding to a punctured or erased bit, a row comprising a 1 in the column and a 0 in the other columns corresponding to a punctured (or erased) bit. Consequently, with n punctured (or erased) bits, the LDPC may comprise at least n rows having exactly one 1 / non-binary / non-zero value in the columns corresponding to punctured (or erased) bits.

Another constraint also refers to the number of 1s / non-binary / non-zero values in the columns corresponding to punctured (or erased) bits. For example, the one or more constraints may comprise, that, in a row for a given check node, at most two 1s / non-binary / non-zero values are present in columns corresponding to punctured (or erased) bits (for example 0, 1 or 2 1s / non-binary / non-zero values). In other words, the LDPC matrix may comprise, in each row, at most two 1s / non-binary / non-zero values in columns corresponding to punctured (or erased) bits.

Additionally, the column weight may be constrained. In general, the "weight" of a column of the matrix may refer to the number of 1s / non-binary / non-zero values that are present in the column. The one or more constraints may comprise, that each column corresponding to a punctured (or erased) bit has a column weight of at least 5 (or at least 7) and at most 40 (or at most 35).

For example, the LDPC matrix may conform to one, two, or all of the above constraints.

The input circuitry or input means 12 may correspond to one or more inputs for receiving information, which may be in digital (bit) values according to a specified code, within a module, between modules or between modules of different entities. For example, the input circuitry or input means 12 may comprise interface circuitry configured to receive information.

In examples the processing circuitry or processing means 14 may be implemented using one or more processing units, one or more processing devices, any means for processing, such as a processor, a computer or a programmable hardware component being operable with accordingly adapted software. In other words, the described function of the processing circuitry or processing means 14 may as well be implemented in software, which is then executed on one or more programmable hardware components. Such hardware components may comprise a general-purpose processor, a Digital Signal Processor (DSP), a micro-controller, etc.

The output circuitry or output means 16 may correspond to one or more outputs for transmitting information, which may be in digital (bit) values according to a specified code, within a module, between modules or between modules of different entities. For example, the output circuitry or output means 16 may comprise interface circuitry configured to transmit information.

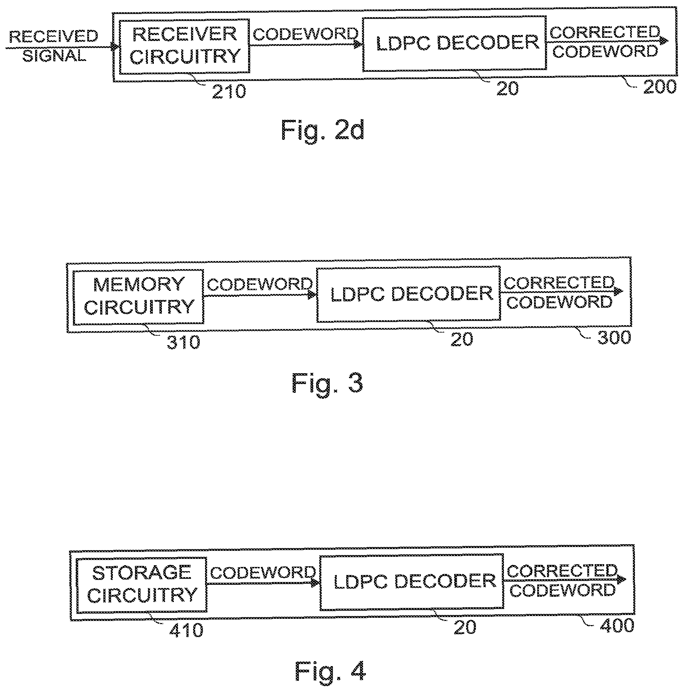

More details and aspects of the apparatus, device or method are mentioned in connection with the proposed concept or one or more examples described above or below (e.g. Fig. 2a to 6e). The apparatus, device or method may comprise one or more additional optional features corresponding to one or more aspects of the proposed concept or one or more examples described above or below.

Fig. 2a shows a block diagram of an example of a decoder apparatus 20 or of a decoder device 20 for decoding an LDPC codeword. The components of the decoder device 20 are defined as component means, which may be implemented using the respective structural components of the decoder apparatus. The decoder apparatus / device comprises processing circuitry / processing means 24. In some examples, the decoder apparatus / device further comprises input circuitry / means 22 and/or output circuitry / means 26, which are coupled to the processing circuitry / means 24, and which may be used to input or output information. For example, the processing circuitry may be configured to obtain a codeword via the input circuitry, and/or to output a corrected codeword via the output circuitry. The decoder apparatus / device may further comprise memory for storing an LDPC matrix, e.g. the LDPC matrix generated in connection with Figs. 1a to 1b, and for storing intermediate value.

The processing circuitry / means 24 is configured to perform LDPC iterative decoding on the LDPC codeword using a soft-decision decoding algorithm. The LDPC iterative decoding is based on the LDPC matrix. The LDPC matrix is generated for codewords with one or more punctured or erased bits, e.g. using the concept shown in connection with Figs. 1a and/or 1b. Accordingly, the codeword may comprise one or more punctured or erased bits. The LDPC matrix adheres to one or more of the following constraints: a) for each column corresponding to a punctured (or erased) bit, the LDPC matrix comprises a row comprising a 1 in the column and a 0 in the other columns corresponding to a punctured (or erased) bit, b) in a row for a given check node, at most two 1s (or non-binary / non-zero values) are present in columns corresponding to punctured (or erased) bits, and c) each column corresponding to a punctured (or erased) bit has a column weight of at least 7 and at most 35. For example, the LDPC matrix may conform to one, two, or all of the above constraints.

Fig. 2b shows a flow chart of an example of a corresponding decoder method for decoding the LDPC codeword. The method comprises performing 220 LDPC iterative decoding on the LDPC codeword using the soft-decision decoding algorithm. For example, the method may further comprise obtaining 210 the codeword, and/or providing 230 a corrected codeword, which may be an output of the soft-decision decoding algorithm after the LDPC iterative decoding.

The following description relate to the decoder apparatus / device and the corresponding decoder method.

While Figs. 1a and/or 1b relate to the generation of the matrix for use in LDPC decoding, Figs. 2a and 2b relate to the application of the matrix. The processing circuitry / means is configured to perform LDPC iterative decoding on the LDPC codeword using the soft-decision decoding algorithm. In general, the LDPC iterative decoding being performed by the processing circuitry may be implemented similar to other systems. As has been mentioned before, an LDPC decoder takes a codeword as an input, and uses the LDPC matrix to calculate a syndrome of the codeword (using a matrix multiplication). In general, such a matrix might not be taken literally - in a hardware implementation, look-up tables or other data constructs may be used to represent the LDPC matrix. The component "low-density" in LDPC refers to the sparseness of the H matrix, in which only few non-zero elements (e.g. logical ones, or other non-binary values when a non-binary LDPC code is used) are interspersed among zeros. The syndrome indicates whether the codeword is correct - if the syndrome is 0 (i.e. all bits of the logical syndrome are logical 0) the codeword is correct. If not, or rather as long as this is not the case (and a maximal number of iterations has not been reached), an iterative process involving message passing is used to correct the code word, by passing "messages" between the variable bit nodes (of the codeword) and the so-called check nodes (of the syndrome) according to a decoder algorithm. Accordingly, the soft-decision decoding algorithm is a message-passing algorithm, i.e. an algorithm that comprises the passing of "messages" between the codeword and the check nodes. At the respective bit nodes or check nodes, the message being passed in input into a logical and/or mathematical transformation, and the result of the transformation is passed back to the respective other nodes. In various examples, the soft-decision decoding algorithm may be a belief-propagation-based algorithm or a min-sum-based algorithm. In belief-propagation-based algorithms, the messages are probabilities which represent a reliability (a "level of belief') about the value of the code bits. In a min-sum-based algorithm, which is a special form of the sum-product-algorithm, a priori probabilities of received bits are used as inputs, and a posteriori probabilities for the bits are given as an output. Compared to the sum-product-algorithm, min-sum-based algorithms use less complex mathematical transformations, which may require less complex hardware. In more general terms, each of the named algorithms may be implemented in hardware, either by using dedicated decoder hardware, or by using a microprocessor for decoding the codeword. In other words, the processing circuitry / means may be implemented by application-specific integrated circuitry, using logical gates and memory cells that are purpose-built for providing the functionality of the processing circuitry.

The LDPC is based on the LDPC matrix, which in turn adheres to one or more of the mentioned constraints. More details with respect to the LDPC matrix can be found in connection with the generation apparatus / device / method of Figs. 1a and/or 1b. The LDPC matrix is generated for codewords with one or more punctured or erased bits. Accordingly, the codeword may comprise one or more punctured or erased bits. For example, the soft-decision decoding algorithm may be an algorithm for processing codewords with one or more punctured or erased bits. Accordingly, oft-decision decoding algorithm take into account the one or more punctured or erased bits, e.g. by initializing them with an "unknown" value, or by setting their "belief' or "reliability" to a low (or zero) value.

The input circuitry or input means 22 may correspond to one or more inputs for receiving information, which may be in digital (bit) values according to a specified code, within a module, between modules or between modules of different entities. For example, the input circuitry or input means 22 may comprise interface circuitry configured to receive information.

In examples the processing circuitry or processing means 24 may be implemented using one or more processing units, one or more processing devices, any means for processing, such as a processor, a computer or a programmable hardware component being operable with accordingly adapted software. In other words, the described function of the processing circuitry or processing means 24 may as well be implemented in software, which is then executed on one or more programmable hardware components. Such hardware components may comprise a general-purpose processor, a Digital Signal Processor (DSP), a micro-controller, etc.

The output circuitry or output means 26 may correspond to one or more outputs for transmitting information, which may be in digital (bit) values according to a specified code, within a module, between modules or between modules of different entities. For example, the output circuitry or output means 26 may comprise interface circuitry configured to transmit information.

Fig. 2c shows a block diagram of an example of a communication device comprising an LDPC decoder apparatus or device 20. The communication device 200 comprises receiver circuitry (or receiver means / means for receiving) 210 and the LDPC decoder apparatus or device 20. The LDPC decoder apparatus or device is configured to decode codewords received via the receiver circuitry. For example, the receive circuitry may be configured to receive signals comprising codewords using a wireless communication system (such as a Wireless Local Area Network, or a wireless communication system as defined by the third-generation partnership projection, 3GPP) or using a wireline communication system, e.g. using a cable communication system, a digital subscriber line communication system or using a passive optical network-based communication system. For example, the communication device may be a communication device for communicating via a passive optical network.

More details and aspects of the communication device are introduced in connection with the proposed concept or one or more examples described above or below (e.g. Fig. 1a to 1b, 3 to 6e). The communication device may comprise one or more additional optional features corresponding to one or more aspects of the proposed concept or one or more examples described above or below.

Fig. 3 shows a block diagram of an example of a memory device comprising an LDPC decoder apparatus or device 20. The memory device 300 comprises memory circuitry (or memory / memory means) 310, e.g. volatile memory or persistent memory, and the LDPC decoder apparatus or device 20. The LDPC decoder apparatus or device is configured to decode codewords obtained from the memory circuitry. For example, the memory device may be a Dual In-line Memory Module (DIMM), or a memory module having another form factor and/or connection infrastructure such as Compute Express Link (CXL), Peripheral Component Interconnect Express (PCIe) or NVMe (Non-Volatile Memory Express). In some examples, the memory device may be a persistent memory device, i.e. a memory device that enables a persistent storage of the information held in the memory. For example, the memory device may use three-dimensional cross-point memory, such as Intel^{®} 3D XPoint^{™}-based persistent memory.

In some examples, the memory device may be a memory device for implementing two-level memory (2LM). In some examples, where the memory device is configured as a 2LM system, the memory device 300 may serve as main memory for a computing device. For these examples, memory circuitry 310 may include the two levels of memory including cached subsets of system disk level storage. In this configuration, the main memory may include "near memory" arranged to include volatile types on memory and "far memory" arranged to include volatile or non-volatile types of memory. The far memory may include volatile or non-volatile memory that may be larger and possibly slower than the volatile memory included in the near memory. The far memory may be presented as "main memory" to an operating system (OS) for the computing device while the near memory is a cache for the far memory that is transparent to the OS. The management of the 2LM system may be done by a combination of logic and modules executed via processing circuitry (e.g., a CPU) of the computing device. Near memory may be coupled to the processing circuitry via high bandwidth, low latency means for efficient processing. Far memory may be coupled to the processing circuitry via low bandwidth, high latency means.

In some examples, the memory circuitry 310 may include non-volatile and/or volatile types of memory. Non-volatile types of memory may include, but are not limited to, 3-dimensional cross-point memory, flash memory, ferroelectric memory, silicon-oxide-nitride-oxide-silicon (SONOS) memory, polymer memory such as ferroelectric polymer memory, nanowire, ferroelectric transistor random access memory (FeTRAM or FeRAM), ovonic memory, nanowire or electrically erasable programmable read-only memory (EEPROM). Volatile types of memory may include, but are not limited to, dynamic random-access memory (DRAM) or static RAM (SRAM).

More details and aspects of the memory device are introduced in connection with the proposed concept or one or more examples described above or below (e.g. Fig. 1a to 2d, 4 to 6e). The memory device may comprise one or more additional optional features corresponding to one or more aspects of the proposed concept or one or more examples described above or below.

Fig. 4 shows a block diagram of an example of a storage device comprising an LDPC decoder apparatus or device 20. The storage device 400 comprises storage circuitry (or storage means / storage) 410, e.g. flash-based storage circuitry or solid-state storage circuitry, and the LDPC decoder apparatus or device 20. The LDPC decoder apparatus or device is configured to decode codewords obtained from the storage circuitry. For example, the storage device may be a solid-state storage device, e.g. a flash-based storage device, such as a solid-state drive. For example, the storage device may be a Compute Express Link (CXL)-, Peripheral Component Interconnect Express (PCIe)- or NVMe (Non-Volatile Memory Express)-based storage device. Other possible interfaces for storage devices include serial ATA (SATA), serial attached SCSI (SAS) or universal serial bus (USB). For example, the storage device may be configured to communicate with a host device via a bus, such as a Peripheral Component Interconnect (PCIe), Serial Advanced Technology Attachment (SA-TA), Serial Attached Small Computer System Interface (SAS)) or a network, such as the Internet, a storage area network (SAN), a local area network (LAN), etc. For example, the storage circuitry 410 may be implemented using non-volatile memory, such as 3-dimensional cross-point memory, flash memory, ferroelectric memory, silicon-oxide-nitride-oxide-silicon (SONOS) memory, polymer memory such as ferroelectric polymer memory, nanowire, ferroelectric transistor random access memory (FeTRAM or FeRAM), ovonic memory, nanowire or electrically erasable programmable read-only memory (EEPROM). In some examples, the storage circuitry 410 may also include types of storage mediums such as optical discs to include, but not limited to, compact discs (CDs), digital versatile discs (DVDs), a high definition DVD (HD DVD) or a Blu-ray disc.

More details and aspects of the storage device are introduced in connection with the proposed concept or one or more examples described above or below (e.g. Fig. 1a to 3, 5a to 6e). The storage device may comprise one or more additional optional features corresponding to one or more aspects of the proposed concept or one or more examples described above or below.

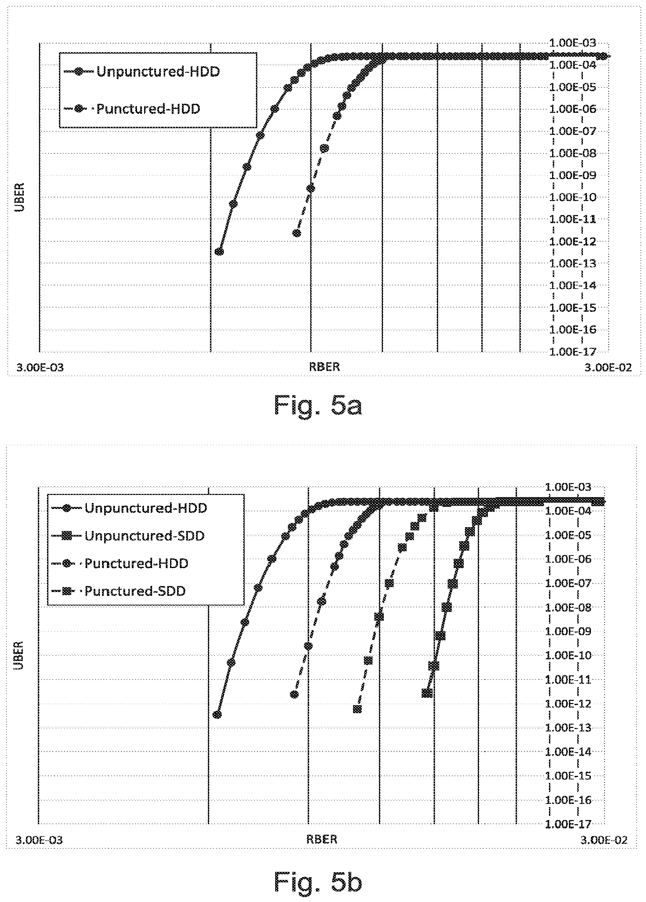

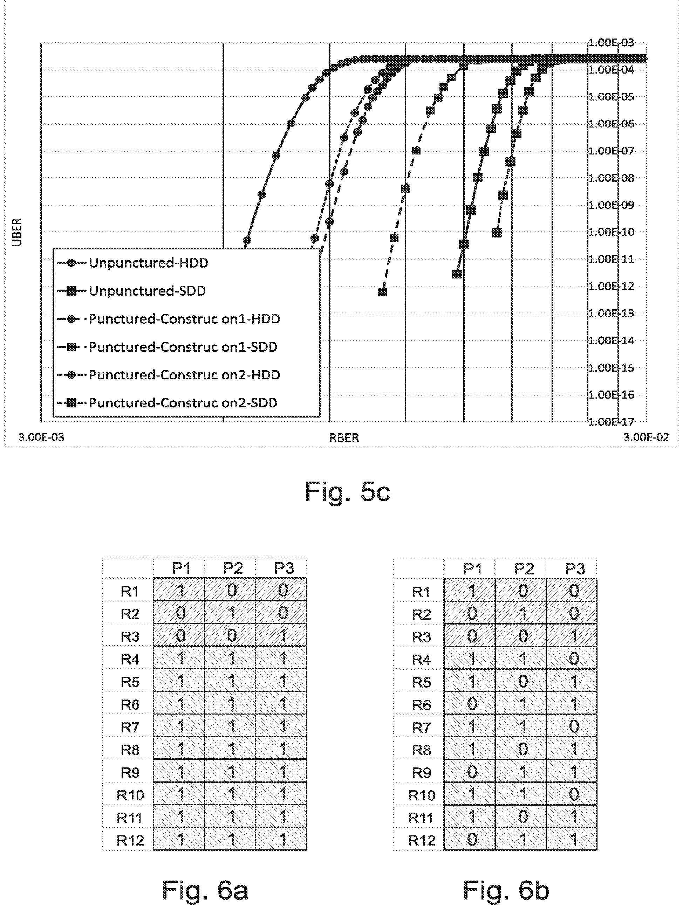

Error control codes (ECC) are an integral part of communication systems. Today, most of the ECC schemes are based on low-density parity-check (LDPC) codes. In several of these configurations, the LDPC decoder needs to recover from both errors and erasures. While errors are typically introduced when reading from the media, erasures arise for different reasons in different products. For example, in three-dimensional cross-point memory products, when there is a die fail, the decoder may erase that portion of the codeword stored in the failed die and attempts a decoding. Also, in several communication systems, a single LDPC code is designed to support multiple data and parity sizes. In such a case, a jumbo code is designed with largest data and parity sizes (among all the supported configurations) and the resulting codeword is appropriately punctured and shortened to support the configuration. In addition, constructing codes with appropriately designed punctured bits provides much superior decoding performance (See Fig. 5a for illustration). When decoding a codeword with punctured bits, the decoder may erase the punctured bits and attempt combined errors and erasure decoding. As seen in Fig. 5a, by adding punctured bits, there can be substantial gain in the hard decision decoding performance of the LDPC codes. Fig. 5a shows a diagram showing a performance comparison in Punctured vs Unpunctured Codes for Hard Decision Decoding (HDD). In Fig. 5a, as in Fig. 5b and 5c, the x-axis shows the Raw Bit-Error Rate (RBER), and the y-axis shows the Uncorrectable Bit Error Rate (UBER). As shown in Fig. 5a, by using punctured bits, a ratio between RBER and UBER improves.

Now, for the same code, the soft-decision decoding performance is considered, which is shown in Fig. 5b. Fig. 5b shows a diagram showing a performance comparison in Punctured vs Unpunctured Codes for Hard Decision Decoding (HDD) and Soft Decision Decoding (SDD). As can be seen, gains in the hard-decision decoding with punctured bits do not automatically translate to the gains in the soft-decision decoding. In fact, the soft read performance is significantly worse, which runs counter to the gains in the hard decision decoding. As can be seen in Fig. 5b, the best performance is obtained from unpunctured SDD, followed by punctured SDD, punctured HDD and unpunctured HDD. Various examples of the present disclosure may mitigate this issue.

Various examples of the present disclosure may provide a method for designing the LDPC code so that the erased or punctured bits do not degrade, but instead improve the performance of the soft read channel. To see the benefits of the proposed scheme (Construction-2), its performance is compared with Construction-1 (the construction used in Fig. 5b) in Fig. 5c. Fig. 5c shows a diagram showing a performance comparison in Punctured Codes according to a first construction (as used in Fig. 5b), Punctured Codes according to a second construction (as proposed in the present disclosure) and Unpunctured Codes for Hard Decision Decoding and Soft Decision Decoding. As can be seen, the best performance can be reached with Construction-2 Punctured Codes with SDD, followed by Unpunctured Codes with SDD, Construction-1 Punctured Codes with HDD, Construction 1 Punctured Codes with SDD, Construction-2 Punctured Codes with HDD and finally Unpunctured Codes with HDD.

Other approaches for soft reads limit the usage of punctured bits, but this limits the gain achievable for both hard and soft reads. With the proposed concept, by carefully designing punctured bits, the gains in both hard and soft reads can be leveraged.

The primary difference between the Construction-1 and Construction-2 in Fig. 5c is its connection profile in the punctured bits. This is illustrated in Fig. 6a and 6b. Figs. 6a and 6b show the connection differences for punctured bits (PI, P2, P3) between Construction-1 (Fig. 6a) and Construction-2 (Fig. 6b), R1-R12 represent the Check-Nodes. Having several simultaneously punctured bits in a given check-node seems to help the hard decision decoding (as in Construction-1), but it degrades the soft read performance significantly. Limiting the simultaneously punctured bits in a given check-node to two recovers most of the hard decision decoding gain, and significantly improves the soft read performance.

In order to obtain good soft-read performance for LDPC codes, various examples of the present disclosure are based on the finding that the connection profile among the punctured (or erased) bits may satisfy one or more of the following criteria:
- The bits that were erased or punctured are to be recoverable in the first two iterations,
- For any given check-node, no more than two punctured or erased bits are to be present, and
- The optimal column weight for the punctured or erased bits should be in the range 7 to 35.

Based on these observations, below, some examples of configurations are provided that illustrate the connectivity profile in punctured bits for good soft read performance.

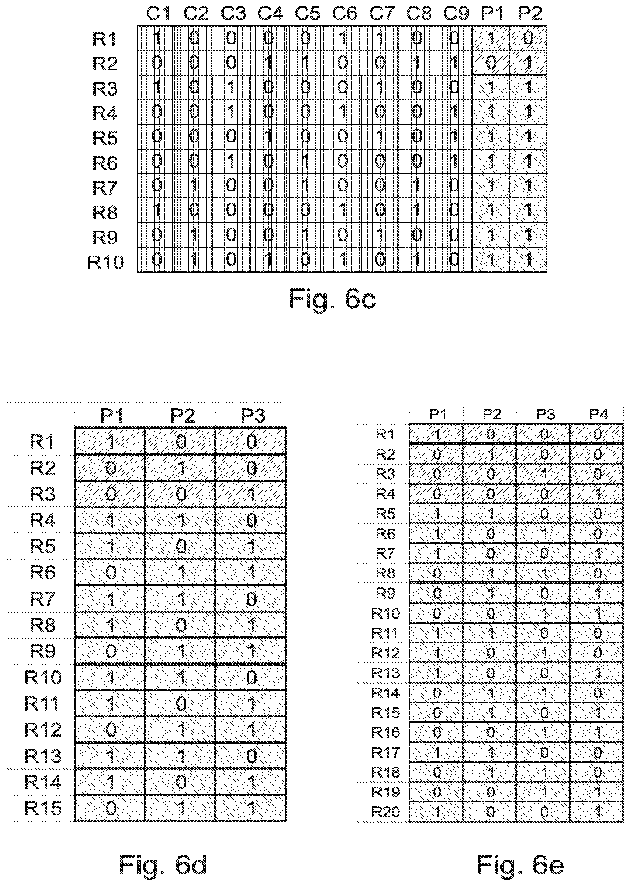

Fig. 6c shows an example configuration for two punctured nodes in the base graph (PI & P2 are punctured bits, C1-C9 are code bits, R1-R10 are the check-nodes). As can be seen from the matrix, for each punctured bit, there is one row with a 1 in the column of the punctured bit, and with no other entry in a punctured bit column being 1. Apart from these rows, the remaining entries for the punctured bits are all 1.

Fig. 6d shows an example configuration with 3 punctured nodes, and Fig. 6e shows a configuration for 4 punctured nodes in the base graph. The same constraints apply here - for each punctured bit, there is one row with a 1 in the column of the punctured bit, and with no other entry in a punctured bit column being 1. Also none of the rows have more than two 1s in punctured bit columns.

Various examples of the present disclosure provide a systematic methodology to construct LDPC codes with punctured or erased bits that show improved performance with soft reads. With this technique, a design of LDPC codes with much better correction strength in the soft reads is facilitated. This may result in significant savings in terms of the reliability of the system.

A coding architecture that supports punctured bits uses an erasure decoding mode. When decoding an error-free codeword, without erasure decoding, a decoder may quickly (within a few clocks) declare a decode success without much activity. Otherwise, with erasure decoding being used, even for error-free codewords, the decoder performs a few iterations.

More details and aspects of the proposed concept are mentioned in connection with the proposed concept or one or more examples described above or below (e.g. Fig. 1a to 4). The proposed concept may comprise one or more additional optional features corresponding to one or more aspects of the proposed concept or one or more examples described above or below.

The aspects and features described in relation to a particular one of the previous examples may also be combined with one or more of the further examples to replace an identical or similar feature of that further example or to additionally introduce the features into the further example.

Example 1 relates to an apparatus (10) for generating a low-density parity-check code, LDPC, matrix, the apparatus comprising processing circuitry (14) configured to generate the LDPC matrix using a generator algorithm, wherein the LDPC matrix is generated for codewords with one or more punctured or erased bits, wherein the LDPC matrix is generated observing one or more constraints.

In Example 2, the subject matter of example 1 or any of the Examples described herein may further include, that the one or more constraints comprise, that for a given check node, the bits that were erased or punctured are recoverable in the first two iterations of a corresponding LDPC iterative decoding algorithm.

In Example 3, the subject matter of example 2 or any of the Examples described herein may further include, that the bits that were erased or punctured are recoverable in the first two iteration by including, for each column corresponding to a punctured or erased bit, a row comprising a 1 in the column and a 0 in the other columns corresponding to a punctured or erased bit.

In Example 4, the subject matter of one of the examples 1 to 3 or any of the Examples described herein may further include, that the one or more constraints comprise, that, in a row for a given check node, at most two 1s are present in columns corresponding to punctured or erased bits.

In Example 5, the subject matter of one of the examples 1 to 4 or any of the Examples described herein may further include, that the one or more constraints comprise, that each column corresponding to a punctured or erased bit has a column weight of at least 7 and at most 35.

In Example 6, the subject matter of one of the examples 1 to 5 or any of the Examples described herein may further include, that the LDPC matrix is an LDPC matrix for use with an LDPC soft-decision decoding algorithm.

In Example 7, the subject matter of one of the examples 1 to 6 or any of the Examples described herein may further include, that the LDPC matrix comprises a plurality of columns corresponding to a plurality of code bits of the codeword, and one or more columns corresponding to one or more punctured or erased bits of the codeword.

Example 8 relates to a decoding apparatus (20) for decoding a low-density parity-check code, LDPC, codeword, the apparatus comprising processing circuitry (24) configured to perform LDPC iterative decoding on the LDPC codeword using a soft-decision decoding algorithm, the LDPC iterative decoding being based on an LDPC matrix, wherein the LDPC matrix is generated for codewords with one or more punctured or erased bits, the codeword comprising one or more punctured or erased bits, wherein the LDPC matrix adheres to one or more of the following constraints: a) for each column corresponding to a punctured or erased bit, the LDPC matrix comprises a row comprising a 1 in the column and a 0 in the other columns corresponding to a punctured or erased bit, b) in a row for a given check node, at most two 1s are present in columns corresponding to punctured or erased bits, and c) each column corresponding to a punctured or erased bit has a column weight of at least 7 and at most 35.

In Example 9, the subject matter of example 8 or any of the Examples described herein may further include, that the soft-decision decoding algorithm is a message-passing algorithm.

In Example 10, the subject matter of one of the examples 8 to 9 or any of the Examples described herein may further include, that the soft-decision decoding algorithm is a belief-propagation-based algorithm or a min-sum-based algorithm.

Example 11 relates to a communication device (200) comprising receiver circuitry (210) and the decoding apparatus (20) according to one of the examples 8 to 10, wherein the decoding apparatus is configured to decode codewords received via the receiver circuitry.

In Example 12, the subject matter of example 11 or any of the Examples described herein may further include, that the communication device is a communication device for communicating via a passive optical network.

Example 13 relates to a memory device (300) comprising memory circuitry (310) and the decoding apparatus (20) according to one of the examples 8 to 10, wherein the decoding apparatus is configured to decode codewords obtained from the memory circuitry.

Example 14 relates to a storage device (400) comprising storage circuitry (410) and the decoding apparatus (20) according to one of the examples 8 to 10, wherein the decoding apparatus is configured to decode codewords obtained from the storage circuitry.

Example 15 relates to a device (10) for generating a low-density parity-check code, LDPC, matrix, the device comprising processing means (14) configured to generate the LDPC matrix using a generator algorithm, wherein the LDPC matrix is generated for codewords with one or more punctured or erased bits, wherein the LDPC matrix is generated observing one or more constraints.

In Example 16, the subject matter of example 15 or any of the Examples described herein may further include, that the one or more constraints comprise, that for a given check node, the bits that were erased or punctured are recoverable in the first two iterations of a corresponding LDPC iterative decoding algorithm.

In Example 17, the subject matter of one of the examples 15 to 16 or any of the Examples described herein may further include, that the bits that were erased or punctured are recoverable in the first two iteration by including, for each column corresponding to a punctured or erased bit, a row comprising a 1 in the column and a 0 in the other columns corresponding to a punctured or erased bit.

In Example 18, the subject matter of one of the examples 15 to 17 or any of the Examples described herein may further include, that the one or more constraints comprise, that, in a row for a given check node, at most two 1s are present in columns corresponding to punctured or erased bits.

In Example 19, the subject matter of one of the examples 15 to 18 or any of the Examples described herein may further include, that the one or more constraints comprise, that each column corresponding to a punctured or erased bit has a column weight of at least 7 and at most 35.

In Example 20, the subject matter of one of the examples 15 to 19 or any of the Examples described herein may further include, that the LDPC matrix is an LDPC matrix for use with an LDPC soft-decision decoding algorithm.

In Example 21, the subject matter of one of the examples 15 to 20 or any of the Examples described herein may further include, that the LDPC matrix comprises a plurality of columns corresponding to a plurality of code bits of the codeword, and one or more columns corresponding to one or more punctured or erased bits of the codeword.

Example 22 relates to a decoding device (20) for decoding a low-density parity-check code, LDPC, codeword, the device comprising processing means (24) configured to perform LDPC iterative decoding on the LDPC codeword using a soft-decision decoding algorithm, the LDPC iterative decoding being based on an LDPC matrix, wherein the LDPC matrix is generated for codewords with one or more punctured or erased bits, the codeword comprising one or more punctured or erased bits, wherein the LDPC matrix adheres to one or more of the following constraints: a) for each column corresponding to a punctured or erased bit, the LDPC matrix comprises a row comprising a 1 in the column and a 0 in the other columns corresponding to a punctured or erased bit, b) in a row for a given check node, at most two 1s are present in columns corresponding to punctured or erased bits, and c) each column corresponding to a punctured or erased bit has a column weight of at least 7 and at most 35.

In Example 23, the subject matter of example 22 or any of the Examples described herein may further include, that the soft-decision decoding algorithm is a message-passing algorithm.

In Example 24, the subject matter of one of the examples 22 to 23 or any of the Examples described herein may further include, that the soft-decision decoding algorithm is a belief-propagation-based algorithm or a min-sum-based algorithm.

Example 25 relates to a communication device (200) comprising receiver means (210) and the decoding device (20) according to one of the examples 22 to 24, wherein the decoding device is configured to decode codewords received via the receiver means.

In Example 26, the subject matter of example 25 or any of the Examples described herein may further include, that the communication device is a communication device for communicating via a passive optical network.

Example 27 relates to a memory device (300) comprising memory means (310) and the decoding device (20) according to one of the examples 22 to 26, wherein the decoding device is configured to decode codewords obtained from the memory means.

Example 28 relates to a storage device (400) comprising storage means (410) and the decoding device (20) according to one of the examples 22 to 27, wherein the decoding device is configured to decode codewords obtained from the storage means.

Example 29 relates to a method for generating a low-density parity-check code, LDPC, matrix, the method comprising generating (110) the LDPC matrix using a generator algorithm, wherein the LDPC matrix is generated for codewords with one or more punctured or erased bits, wherein the LDPC matrix is generated observing one or more constraints.

In Example 30, the subject matter of example 29 or any of the Examples described herein may further include, that the one or more constraints comprise, that for a given check node, the bits that were erased or punctured are recoverable in the first two iterations of a corresponding LDPC iterative decoding algorithm.

In Example 31, the subject matter of example 30 or any of the Examples described herein may further include, that the bits that were erased or punctured are recoverable in the first two iterations of a corresponding LDPC iterative decoding algorithm by including, for each column corresponding to a punctured or erased bit, a row comprising a 1 in the column and a 0 in the other columns corresponding to a punctured or erased bit.

In Example 32, the subject matter of one of the examples 29 to 31 or any of the Examples described herein may further include, that the one or more constraints comprise, that, in a row for a given check node, at most two 1s are present in columns corresponding to punctured or erased bits.

In Example 33, the subject matter of one of the examples 29 to 32 or any of the Examples described herein may further include, that the one or more constraints comprise, that each column corresponding to a punctured or erased bit has a column weight of at least 7 and at most 35.

In Example 34, the subject matter of one of the examples 29 to 33 or any of the Examples described herein may further include, that the LDPC matrix is an LDPC matrix for use with a soft-read LDPC iterative decoding algorithm.

In Example 35, the subject matter of one of the examples 29 to 34 or any of the Examples described herein may further include, that the LDPC matrix comprises a plurality of columns corresponding to a plurality of code bits of the codeword, and one or more columns corresponding to one or more punctured or erased bits of the codeword.

Example 36 relates to a decoding method for decoding a low-density parity-check code, LDPC, codeword, the method comprising performing (220) LDPC iterative decoding on the LDPC codeword using a soft-decision decoding algorithm, the LDPC iterative decoding being based on an LDPC matrix, wherein the LDPC matrix is generated for codewords with one or more punctured or erased bits, the codeword comprising one or more punctured or erased bits, wherein the LDPC matrix adheres to one or more of the following constraints:
a) for each column corresponding to a punctured or erased bit, the LDPC matrix comprises a row comprising a 1 in the column and a 0 in the other columns corresponding to a punctured or erased bit, b) in a row for a given check node, at most two 1s are present in columns corresponding to punctured or erased bits, and c) each column corresponding to a punctured or erased bit has a column weight of at least 7 and at most 35.

In Example 37, the subject matter of example 36 or any of the Examples described herein may further include, that the soft-decision decoding algorithm is a message-passing algorithm.

In Example 38, the subject matter of one of the examples 29 to 37 or any of the Examples described herein may further include, that the soft-decision decoding algorithm is a belief-propagation-based algorithm or a min-sum-based algorithm.

Example 39 relates to a machine-readable storage medium including program code, when executed, to cause a machine to perform the method of one of the examples 29 to 35, or the method of one of the examples 36 to 38.

Example 40 relates to a computer program having a program code for performing the method of one of the examples 29 to 35, or the method of one of the examples 36 to 38, when the computer program is executed on a computer, a processor, or a programmable hardware component.

Example 41 relates to a machine-readable storage including machine readable instructions, when executed, to implement a method or realize an apparatus as claimed in any pending claim or shown in any example.

Examples may further be or relate to a (computer) program including a program code to execute one or more of the above methods when the program is executed on a computer, processor or other programmable hardware component. Thus, steps, operations, or processes of different ones of the methods described above may also be executed by programmed computers, processors, or other programmable hardware components. Examples may also cover program storage devices, such as digital data storage media, which are machine-, processor- or computer-readable and encode and/or contain machine-executable, processor-executable or computer-executable programs and instructions. Program storage devices may include or be digital storage devices, magnetic storage media such as magnetic disks and magnetic tapes, hard disk drives, or optically readable digital data storage media, for example. Other examples may also include computers, processors, control units, (field) programmable logic arrays ((F)PLAs), (field) programmable gate arrays ((F)PGAs), graphics processor units (GPU), application-specific integrated circuits (ASICs), integrated circuits (ICs) or system-on-a-chip (SoCs) systems programmed to execute the steps of the methods described above.

It is further understood that the disclosure of several steps, processes, operations or functions disclosed in the description or claims shall not be construed to imply that these operations are necessarily dependent on the order described, unless explicitly stated in the individual case or necessary for technical reasons. Therefore, the previous description does not limit the execution of several steps or functions to a certain order. Furthermore, in further examples, a single step, function, process, or operation may include and/or be broken up into several sub-steps, -functions, -processes or -operations.

If some aspects have been described in relation to a device or system, these aspects should also be understood as a description of the corresponding method. For example, a block, device or functional aspect of the device or system may correspond to a feature, such as a method step, of the corresponding method. Accordingly, aspects described in relation to a method shall also be understood as a description of a corresponding block, a corresponding element, a property or a functional feature of a corresponding device or a corresponding system.

The following claims are hereby incorporated in the detailed description, wherein each claim may stand on its own as a separate example. It should also be noted that although in the claims a dependent claim refers to a particular combination with one or more other claims, other examples may also include a combination of the dependent claim with the subject matter of any other dependent or independent claim. Such combinations are hereby explicitly proposed, unless it is stated in the individual case that a particular combination is not intended. Furthermore, features of a claim should also be included for any other independent claim, even if that claim is not directly defined as dependent on that other independent claim.

## Claims

1. A decoder apparatus for decoding a low-density parity-check code, LDPC, codeword, the apparatus comprising processing circuitry configured to:
perform LDPC iterative decoding on the LDPC codeword using a soft-decision decoding algorithm, the LDPC iterative decoding being based on an LDPC matrix,
wherein the LDPC matrix is generated for codewords with one or more punctured or
erased bits, the codeword comprising one or more punctured or erased bits,
wherein the LDPC matrix adheres to one or more of the following constraints:
a) for each column corresponding to a punctured or erased bit, the LDPC matrix comprises a row comprising a 1 in the column and a 0 in the other columns corresponding to a punctured or erased bit,
b) in a row for a given check node, at most two 1s are present in columns corresponding to punctured or erased bits, and
c) each column corresponding to a punctured or erased bit has a column weight of at least 7 and at most 35.

2. The decoder apparatus according to claim 1, wherein the soft-decision decoding algorithm is a message-passing algorithm.

3. The decoder apparatus according to one of the claims 1-2, wherein the soft-decision decoding algorithm is a belief-propagation-based algorithm or a min-sum-based algorithm.

4. The decoder apparatus according to one of the claims 1-3, wherein the decoder apparatus is a communication device comprising receiver circuitry, wherein the decoder apparatus is configured to decode codewords received via the receiver circuitry.

5. The communication device according to claim 4, wherein the decoder apparatus is a communication device for communicating via a passive optical network.

6. The decoder apparatus according to one of the claims 1-5, wherein the decoder apparatus is a memory device comprising memory circuitry, wherein the decoder apparatus is configured to decode codewords obtained from the memory circuitry.

7. The decoder apparatus according to one of the claims 1-6, wherein the decoder apparatus is a storage device comprising storage circuitry, wherein the decoder apparatus is configured to decode codewords obtained from the storage circuitry.

8. An apparatus for generating a low-density parity-check code, LDPC, matrix, the apparatus comprising processing circuitry configured to generate the LDPC matrix using a generator algorithm,
wherein the LDPC matrix is generated for codewords with one or more punctured or erased bits,
wherein the LDPC matrix is generated observing one or more constraints.

9. The apparatus according to claim 8, wherein the one or more constraints comprise, that for a given check node, the bits that were erased or punctured are recoverable in the first two iterations of a corresponding LDPC iterative decoding algorithm.

10. The apparatus according to claim 9, wherein the bits that were erased or punctured are recoverable in the first two iteration by including, for each column corresponding to a punctured or erased bit, a row comprising a 1 in the column and a 0 in the other columns corresponding to a punctured or erased bit.

11. The apparatus according to one of the claims 8-10, wherein the one or more constraints comprise, that, in a row for a given check node, at most two 1s are present in columns corresponding to punctured or erased bits.

12. The apparatus according to claim 8, wherein the one or more constraints comprise, that each column corresponding to a punctured or erased bit has a column weight of at least 7 and at most 35.

13. The apparatus according to one of the claims 8-12, wherein the LDPC matrix is an LDPC matrix for use with an LDPC soft-decision decoding algorithm.

14. A decoding method for decoding a low-density parity-check code, LDPC, codeword, the method comprising
performing (220) LDPC iterative decoding on the LDPC codeword using a soft-decision decoding algorithm, the LDPC iterative decoding being based on an LDPC matrix, wherein the LDPC matrix is generated for codewords with one or more punctured or erased bits, the codeword comprising one or more punctured or erased bits,
wherein the LDPC matrix adheres to one or more of the following constraints: a) for each column corresponding to a punctured or erased bit, the LDPC matrix comprises a row comprising a 1 in the column and a 0 in the other columns corresponding to a punctured or erased bit, b) in a row for a given check node, at most two 1s are present in columns corresponding to punctured or erased bits, and c) each column corresponding to a punctured or erased bit has a column weight of at least 7 and at most 35.

15. A computer program having a program code for performing the method of claim 14, or the method of one of the examples 36 to 38, when the computer program is executed on a computer, a processor, or a programmable hardware component.
